# EUROPEAN PATENT APPLICATION

(11) **EP 4 575 643 A1**
(43) Date of publication of application: **25.06.2025**
(21) Application number: 23218173.5
(22) Date of filing: 19.12.2023
(51) Int. Cl.: G03F 7/20

(54) **EUV SOURCE CONTROL WITH CONSTANT OR SLOWLY CHANGING LEVEL OF AVERAGE LASER OUTPUT POWER FOR A LITHOGRAPHIC APPARATUS**

(71) Applicant: ASML Netherlands B.V., 5500 AH Veldhoven (NL)
(72) Inventor: WARNAAR, Bastiaan, 5500AH Veldhoven (NL); BOERMAN, Willem, 5500AH Veldhoven (NL)
(74) Representative: ASML Netherlands B.V.

(57) **Abstract**

Disclosed herein is a lithographic apparatus comprising: an EUV source that comprises a laser; and a control system; wherein: the control system is configured to obtain timing data of intended exposure processes; and the control system is configured to determine, in dependence on at least the timing data, control data for changing the instantaneous output power of the laser such that, during the intended exposure processes, an average output power of the laser is substantially maintained at a constant level, or changes at, or slower than, a pre-determined rate.

## Description

### FIELD

The present invention relates to the control of the laser of an EUV source of a lithographic apparatus. Embodiments may determine how to control the laser such that the temperature variation of optical elements in the EUV source is reduced. The overall power consumption of the EUV source may also be reduced.

### BACKGROUND

A lithographic apparatus is a machine constructed to apply a desired pattern onto a substrate. A lithographic apparatus can be used, for example, in the manufacture of integrated circuits (ICs). A lithographic apparatus may, for example, project a pattern at a patterning device (e.g., a mask) onto a layer of radiation-sensitive material (resist) provided on a substrate.

To project a pattern on a substrate a lithographic apparatus may use electromagnetic radiation. The wavelength of this radiation determines the minimum size of features which can be formed on the substrate. A lithographic apparatus, which uses extreme ultraviolet (EUV) radiation, having a wavelength within the range 4-20 nm, for example 6.7 nm or 13.5 nm, may be used to form smaller features on a substrate than a lithographic apparatus which uses, for example, radiation with a wavelength of 193 nm.

There is a general desire to improve the patterning process by EUV radiation.

### SUMMARY

According to a first aspect of the invention, there is provided a lithographic apparatus comprising: an EUV source that comprises a laser; and a control system; wherein: the control system is configured to obtain timing data of intended exposure processes; and the control system is configured to determine, in dependence on at least the timing data, control data for changing the instantaneous output power of the laser such that, during the intended exposure processes, an average output power of the laser is substantially maintained at a constant level, or changes at, or slower than, a pre-determined rate.

According to a second aspect of the invention, there is provided a method of controlling the operation of a laser of an EUV source in a lithographic apparatus, the method comprising: obtaining timing data of intended exposure processes; and determining, in dependence on at least the timing data, control data for changing the instantaneous output power of the laser such that an average output power of the laser is substantially maintained at a constant level, or changes at, or slower than, a pre-determined rate, during the intended exposure processes.

According to a third aspect of the invention, there is provided an EUV source of a lithographic apparatus according to the first aspect.

According to a fourth aspect of the invention, there is provided a control system of a lithographic apparatus according to the first aspect.

### BRIEF DESCRIPTION OF THE DRAWINGS

Embodiments of the invention will now be described, by way of example only, with reference to the accompanying schematic drawings, in which:
- Figure 1 schematically depicts a lithographic system comprising a lithographic apparatus and a radiation source;
- Figure 2 schematically illustrates the reduce fire between exposure (RFBE) technique; and
- Figure 3 schematically illustrates the operation of a laser during embodiments.

### DETAILED DESCRIPTION

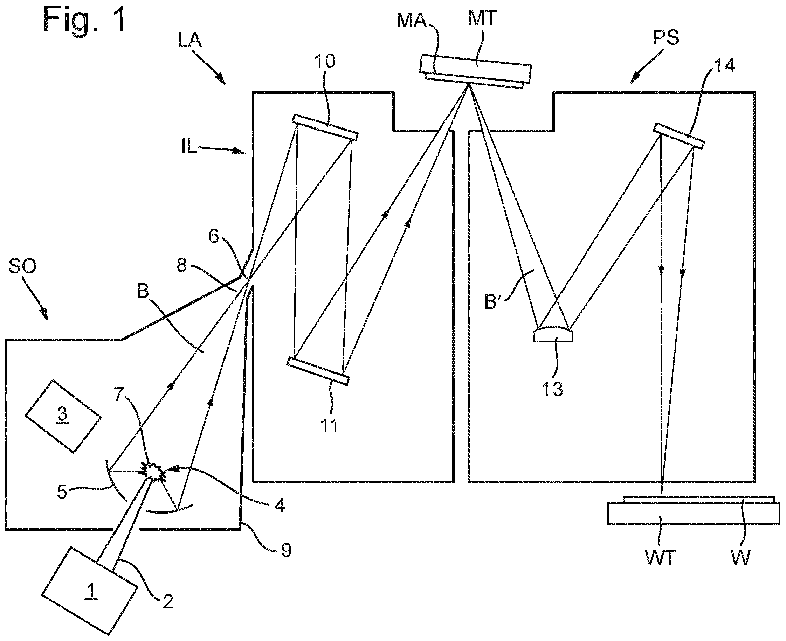

Figure 1 shows a lithographic system comprising a radiation source SO and a lithographic apparatus LA. The radiation source SO is configured to generate an EUV radiation beam B and to supply the EUV radiation beam B to the lithographic apparatus LA. The lithographic apparatus LA comprises an illumination system IL, a support structure MT configured to support a patterning device MA (e.g., a mask), a projection system PS and a substrate table WT configured to support a substrate W.

The illumination system IL is configured to condition the EUV radiation beam B before the EUV radiation beam B is incident upon the patterning device MA. Thereto, the illumination system IL may include a facetted field mirror device 10 and a facetted pupil mirror device 11. The faceted field mirror device 10 and faceted pupil mirror device 11 together provide the EUV radiation beam B with a desired cross-sectional shape and a desired intensity distribution. The illumination system IL may include other mirrors or devices in addition to, or instead of, the faceted field mirror device 10 and faceted pupil mirror device 11.

After being thus conditioned, the EUV radiation beam B interacts with the patterning device MA. As a result of this interaction, a patterned EUV radiation beam B' is generated. The projection system PS is configured to project the patterned EUV radiation beam B' onto the substrate W. For that purpose, the projection system PS may comprise a plurality of mirrors 13,14 which are configured to project the patterned EUV radiation beam B' onto the substrate W held by the substrate table WT. The projection system PS may apply a reduction factor to the patterned EUV radiation beam B', thus forming an image with features that are smaller than corresponding features on the patterning device MA. For example, a reduction factor of 4 or 8 may be applied. Although the projection system PS is illustrated as having only two mirrors 13,14 in Figure 1, the projection system PS may include a different number of mirrors (e.g., six or eight mirrors).

The substrate W may include previously formed patterns. Where this is the case, the lithographic apparatus LA aligns the image, formed by the patterned EUV radiation beam B', with a pattern previously formed on the substrate W.

A relative vacuum, i.e. a small amount of gas (e.g. hydrogen) at a pressure well below atmospheric pressure, may be provided in the radiation source SO, in the illumination system IL, and/or in the projection system PS.

The radiation source SO shown in Figure 1 is, for example, of a type which may be referred to as a laser produced plasma (LPP) source. A laser system 1, which may, for example, include a CO₂ laser, is arranged to deposit energy via a laser beam 2 into a fuel, such as tin (Sn) which is provided from, e.g., a fuel emitter 3. Although tin is referred to in the following description, any suitable fuel may be used. The fuel may, for example, be in liquid form, and may, for example, be a metal or alloy. The fuel emitter 3 may comprise a nozzle configured to direct tin, e.g. in the form of droplets, along a trajectory towards a plasma formation region 4. The laser beam 2 is incident upon the tin at the plasma formation region 4. The deposition of laser energy into the tin creates a tin plasma 7 at the plasma formation region 4. Radiation, including EUV radiation, is emitted from the plasma 7 during de-excitation and recombination of electrons with ions of the plasma.

The EUV radiation from the plasma is collected and focused by a collector 5. Collector 5 comprises, for example, a near-normal incidence radiation collector 5 (sometimes referred to more generally as a normal-incidence radiation collector). The collector 5 may have a multilayer mirror structure which is arranged to reflect EUV radiation (e.g., EUV radiation having a desired wavelength such as 13.5 nm). The collector 5 may have an ellipsoidal configuration, having two focal points. A first one of the focal points may be at the plasma formation region 4, and a second one of the focal points may be at an intermediate focus 6, as discussed below.

The laser system 1 may be spatially separated from the radiation source SO. Where this is the case, the laser beam 2 may be passed from the laser system 1 to the radiation source SO with the aid of a beam delivery system (not shown) comprising, for example, suitable directing mirrors and/or a beam expander, and/or other optics. The laser system 1, the radiation source SO and the beam delivery system may together be considered to be a radiation system.

Radiation that is reflected by the collector 5 forms the EUV radiation beam B. The EUV radiation beam B is focused at intermediate focus 6 to form an image at the intermediate focus 6 of the plasma present at the plasma formation region 4. The image at the intermediate focus 6 acts as a virtual radiation source for the illumination system IL. The radiation source SO is arranged such that the intermediate focus 6 is located at or near to an opening 8 in an enclosing structure 9 of the radiation source SO.

An EUV system is a lithographic apparatus that performs exposure processes during which a substrate W is illuminated by EUV radiation. The time periods during which exposure processes are performed may be referred to as exposure times. The time periods between exposure processes may be referred to as dark times. During the dark times, necessary processes may be performed other than exposure processes. For example, during the dark times a substrate W may be moved so that a new location on the substrate W may be illuminated or a new substrate W in the lot may be loaded and prepared for an exposure process.

As described earlier, the radiation source SO may be a laser produced plasma (LPP) source that includes a laser, that may be a CO₂ laser. The laser is arranged to deposit energy via a laser beam 2 into a fuel. The laser is a high power laser. The energy consumption and operating costs of the laser are therefore high. In known systems, the laser operates continuously during use of the EUV system. The laser therefore operates during the dark times even though no EUV radiation may be required during the dark times.

In order to reduce the energy consumption of the laser, stopping the operation of the laser during the dark times has been considered. In a technique that may be referred to as reduce fire between exposure, RFBE, a control system controls the operation of the laser so that, during a time period for performing a plurality of exposure processes on a substrate W, the laser only operates when each exposure process is performed. RFBE may reduce the power consumption of the laser by about 20kW to 70kW.

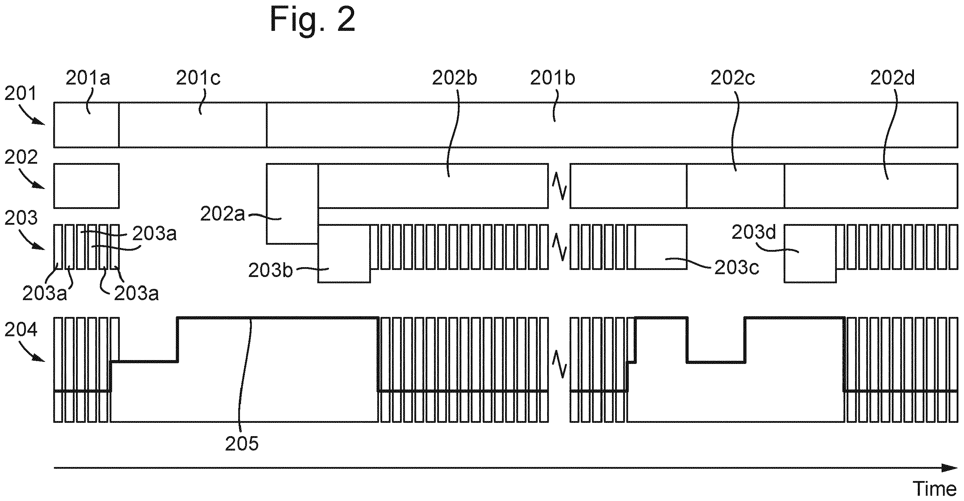

Figure 2 schematically illustrates the RFBE technique. Figure 2 shows different processes that are performed over a time period.

In Figure 2, row 201 shows process with lots of substrates W, row 202 shows process with substrates W within the lots, row 203 shows when radiation from the EUV source is used, and line 205 in row 204 shows the average output power of the laser of the EUV source.

In row 201, there is a time period 201a during which processes are performed with a first lot of substrates W. There is a time period 201b during which processes are performed with a second lot of substrates W. There is a time period 201c between the processes that are performed with the first and second lots of substrates W.

Row 202 shows the time periods of processes performed during the processing of the first and second lots of substrates W. During time period 202a, a number of calibration and/or other non-production steps may be performed before production processes are performed on substrates W in the second lot. During time period 202b, production processes may be performed on a first substrate W in the second lot. During time period 202d, production processes may be performed on a second substrate W in the second lot. There is a time period 202c between the production processes that are performed on the first and second substrates W in the second lot. During this time period 202c, the first substrate W may be unloaded from the substrate table WT, the second substrate W may be loaded onto the substrate table WT, and calibration and/or other processes may be performed.

Row 203 shows the time periods of processes performed during the processing of the substrates W. All of the narrow bars 203a indicate exposure times 203a during which exposure processes are performed on a substrate W and so the substrate W is illuminated by EUV radiation. The dark times are the time periods between the exposure processes. During the dark times, a substrate W is not illuminated by EUV radiation. There are also times 203b, 203c, 203d during which a substrate W may be illuminated by EUV radiation but for a process other than a first exposure process. For example, reticle alignment, die repair or calibration processes may be performed during the times 203b, 203c, 203d.

Row 204 the vertical bars show the instantaneous output power of the laser of the EUV source given the processes that are performed during the different time periods. The RFBE technique is being applied so the laser of the EUV source is not always operated between the exposure times 203a. The laser may be continuously operated during the time periods corresponding to 201c, 202a and 203b. The average output power of the EUV source is shown by line 205. The average output power of the laser of the EUV source is shown by line 205. Line 205 is a moving average of the laser output power that may be determined across a predetermined time period. The predetermined time period may be, for example, a fixed time period between about 0.1 seconds and 100 seconds, such as between about 1 second and 10 seconds.

There are optical elements in the EUV source that prepare the laser beam before it hits a fuel, such as tin, in order to generate EUV radiation. The process of generating EUV radiation may comprise the laser hitting the fuel a plurality of times. When the laser beam is applied, it heats the optical elements. The overall heating of the optical elements in the EUV source is dependent on the average output power of the laser of the EUV source. As indicated by the large difference between the maximum and minimum values of line 205, there is a large change in the average output power of the laser of the EUV source. A problem with RFBE is that the large changes in the average output power of the laser may cause large changes in the average temperature of the optical elements in the EUV source.

The average temperature of optical elements in the EUV source is dependent on the average output power of the laser. When there is a change in average temperature of the optical elements, it may be possible for their operation to be controlled to substantially correct for the performance changes that would otherwise occur. However, there is a limited extent that the control of the operation of optical elements is capable of correcting temperature induced performance changes. There is also a response time required for the control of the operation of optical elements to take effect that limits how quickly performance corrections may be performed. One, or both, of these effects may prevent the use of RFBE because the performance changes caused by the change in average output power of the laser may not be correctable. In addition, the change in average output power of the laser due to the use of RFBE may be so large that it causes the operation of the system to automatically trip to prevent the thermal load change from damaging the optical elements.

Other techniques have been considered for reducing the energy consumption of the laser. For example, US20130051412A1, US20190288478A1 and US20180375283A1 disclose techniques for varying the power in an EUV source. However, all of these techniques experience at least the above described problem of large changes in average power.

Embodiments provide a new technique for controlling the laser of the radiation source SO, i.e. EUV source, of an EUV system. The EUV system may be the above described EUV system. The EUV system comprises a control system arranged to control the operation of the laser. The laser may be the above-described CO₂ laser for a laser produced plasma (LPP) source.

The above-described RFBE technique determines how to control the laser of an EUV source so as to minimise the overall power consumption of the EUV source. RFBE is applied only during the time period(s) allocated for exposure processes on a substrate W. RFBE is not applied during other time periods. Embodiments differ by determining how to control the laser of an EUV source in a way that both reduces the power consumption of the EUV source and also maintains the average output power of the laser within manageable limits. Embodiments differ from RFBE in that the control of the laser is determined during all relevant time periods. The control of the laser is not limited to only being applied during the time period(s) allocated for exposure processes on a substrate W. In particular, embodiments may include determining how to control the laser of an EUV source so as to substantially prevent changes to the average temperature of the optical elements in the EUV source. This may result in the laser of the EUV source being operated, so that the optical elements are heated, when no EUV radiation is generated. The laser may be operated without EUV being generated by the timing of the laser and/or fuel supply being changed, or the laser direction being changed, so that the laser does not hit the fuel. The laser is therefore operated at times at which there is no generation of EUV radiation. Embodiments also include determining how to control the laser of an EUV source so as to ensure that the rate at which the average output power of the laser changes is slow enough for performance changes of the optical elements in the EUV source to be substantially compensated. The determined control of the laser of an EUV source according to embodiments may also reduce the overall power consumption relative to the known technique of the laser operating continuously.

In embodiments, the control system is configured to control the operation of the laser in dependence on all data that is relevant to the exposure processes. The data relevant to the exposure processes may include scanner recipe data and/or operating data.

Scanner recipe data is known data that defines how and when exposure processes are performed. Scanner recipe data is dependent on the user requirements and the technical capabilities of the EUV system. The scanner recipe data may include data on all operations relevant to the use of the EUV source. In particular, the scanner recipe data may include one or more of: the size and location of all of the fields of the substrate W that will be exposed during planned exposure processes, the intended dose that will be used in each exposure process, and throughput data of the lithographic apparatus.

The required laser power is dependent on the size and location of all of the fields of the substrate W that will be exposed during planned exposure processes, as well as the dose used in each exposure process. For example, when different inner fields, or dies, on a substrate W are exposed, the time required to move between the different fields, or dies, is less than when outer fields, or dies, at the edge of the substrate W are exposed. Accordingly, lower laser powers may be used between the exposures of the inner fields, or dies, than for the exposures of the outer fields, or dies.

The throughput data may include any data relevant to the rate at which processes are performed on substrates W. The throughput data may include, for example, the number of lots of substrates W, the number of substrates W in each lot, the time difference between the loading and unloading of consecutive substrates W onto the substrate table WT, the time required for all processes between exposure processes, and the time required for exposure processes.

Scanner recipe data is known data in advance of the start of exposure processes being performed by an EUV system.

According to embodiments, scanner recipe data is provided to a control system. The control system then generates laser control data in dependence on the scanner recipe data. Laser control data is data that comprises instructions on how to control the operation of the laser whilst the EUV system performs the processes defined by the scanner recipe data. In particular, the laser control data comprises instructions that define the on times of the laser, the off times of the laser, and the power of the laser during the on times of the laser.

Over a given time period, the power, on times and off times of the laser may be represented as a percentage of the available output power. For example, if the laser is continuously on over the time period at maximum power, the output power is 100%. If the laser is continuously off over the time period, the output power is 0%. The on times, off times, and used power during the on times may be varied in order to set the output power to a value between 0% and 100%.

The control system may determine the laser control data such that the average output power of the laser does not substantially change during the performed processes in the scanner recipe data. In particular, the laser control data is determined so that the change in average temperature of the optical elements in the EUV source is less than a predetermined threshold value. The threshold value may be such that any performance changes caused by variation in the average temperature of the optical elements are correctable by control of the operation of the optical elements. Preferably, the threshold value is low so that there is substantially no change in the average temperature of the optical elements when the laser is operated in accordance with the laser control data. The threshold value may be less than 5°C, preferably less than 1°C, and more preferably substantially 0°C.

The laser control data may define a dynamic profile for the output power of the laser. For example, it may determine that between the exposures of inner fields, the short dark time required to move between the different fields, which may be about 30ms, allows the output power to be 0% during this dark time. However, for exposures between outer fields, the dark time required to move between the different fields, which may be about 60ms, is longer and so it may determine that an output power of 40% is required during this dark time so as to avoid a substantial change to the average temperature of optical elements in the EUV source. Similarly, during other processes, such as lots of substrates W being changed, substrates W within lots being changed, calibration processes being performed, and when any other processes that the operation of the EUV source is dependent on are performed, the laser may be controlled to have a substantially constant average output power. By operating the laser with a substantially constant average output power, substantial changes to the average temperature of the optical elements in the EUV system are avoided. Embodiments therefore include the laser being operated, so that the optical elements are heated, at times at which no EUV radiation is generated. The laser may be operated without EUV being generated by the timing of the laser and/or fuel supply being changed, or the laser direction being changed, so that the laser does not the fuel.

A control system then controls the operation of the laser of the EUV source, in dependence on the instructions in the laser control data, when the processes corresponding to the scanner recipe data are performed.

The control system that generates the laser control data may be the same control system that controls the operation of the EUV source. Alternatively, the laser control data may be generated by a separate control system from the control system that controls the operation of the EUV source.

Before the exposure processes are started, the control system may make an initial determination of the laser control data that will be used during the exposure processes in dependence on only the scanner recipe data. The exposure processes may then be started with the initially determined laser control data. As the exposure processes are performed, operating data is generated that comprises data on the actual operating conditions. The operating data may include, for example, data collected within the laser itself such as actual used powers given any process corrections that were required, as well previously exposed dies and actual dark times given any process corrections. As the operating data is generated, the control system may change and/or generate the laser control data in dependence on the operating data. The laser control data may therefore be generated in dependence on scanner recipe data and/or operating data. The control system may be configured to control the operation of the laser in dependence on the operating data and/or the scanner recipe data. The scanner recipe data may effectively be coarse data for determining the laser control data. The operating data may effectively be fine data for determining adjustments to the laser control data so as to improve its accuracy.

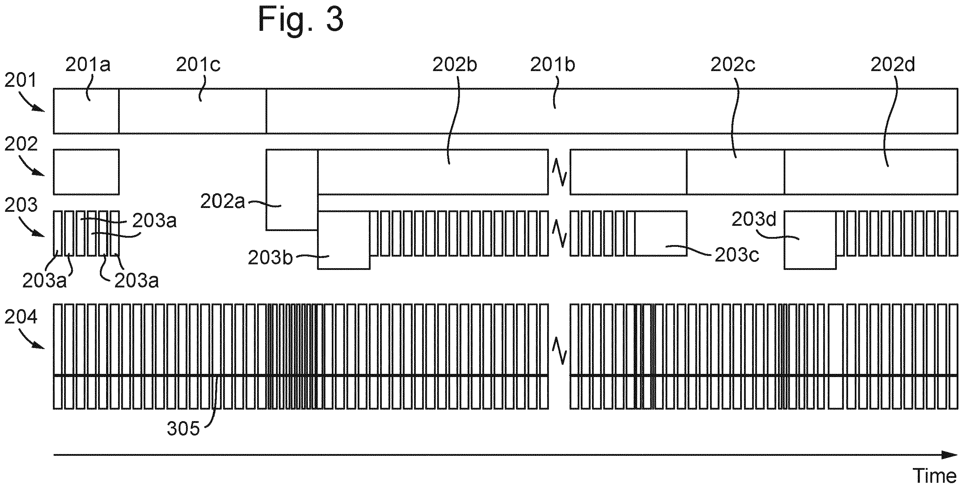

Figure 3 schematically illustrates the techniques according to embodiments, and in particular the operation of the laser in accordance with laser control data determined according to embodiments.

The different processes shown in Figure 3, that are performed over a time period, may the same as described earlier with reference to Figure 2. Accordingly, row 201 shows process with lots of substrates W, row 202 shows process with substrates W within lots, row 203 shows when radiation from the EUV source is used, and line 305 in row 204 shows the average output power of the laser of the EUV source. The shown average output power of the laser of the EUV source by line 305 is a moving average of the output power that may be determined across a predetermined time period. The predetermined time period may be, for example, a fixed time period between about 0.1 seconds and 100 seconds, such as between about 1 second and 10 seconds.

As can be seen from Figure 3, in embodiments the operating times of the laser are different from when RFBE techniques are used. The effect of this is that the average output power of the laser, as shown by line 305, is substantially constant. The average temperature of the optical elements is dependent on the average output power of the laser. Accordingly, embodiments avoid substantial variations in the average temperature of the optical elements in the EUV source. Performance variations caused by a change of the average temperature of the optical elements may therefore be avoided. The lifetime of the optical elements is also improved by the reduced variation in average temperature.

When there is a change in scanner recipe data, such as when a new lot of substrates needs to be processed with different manufacturing requirements, it may be appropriate to change the average output power of the laser of the EUV source. Embodiments include determining, and operating the EUV source with, laser control data that changes the average output power occurs sufficiently slowly for performance variations caused by the change in output power to be compensated for. In particular, the average output power may be changed in a way that avoids any system instability and damage occurring.

Embodiments also include the laser control data controlling the operation of the laser of the EUV source in any of a number of ways. In particular, embodiments include a desired average output power of the laser being provided by the laser operating continuously at a low output power rather than intermittently with a higher output power. For example, over time periods 201c, 202a and 203b in Figure 3, the output power of the laser may be continuous at the level shown by the line 305, instead of line 305 representing the average output power of an intermittently operated laser.

Embodiments include a number of modifications and variations to the above described techniques.

Although the laser control data may be initially predetermined from the scanner recipe data, and adjusted according to the operating data, the laser control data may be dynamically changed during the operation of the EUV source if required. This may be appropriate, for example, if unforeseen circumstances caused the intended exposure processes to be interrupted.

Embodiments have been described with reference to laser control data. The laser control data may more generally be referred to a control data of an EUV source.

Although Figure 1 depicts the radiation source SO as a laser produced plasma (LPP) source, any suitable source such as a discharge produced plasma (DPP) source or a free electron laser (FEL) may be used to generate EUV radiation. Embodiments control the output power of the laser so that it is not always on and is operated so that the average temperature of optical elements in the EUV source is maintained within a correctable range.

Embodiments include projecting a patterned beam of radiation onto a substrate W that is comprised by an EUV tool according to the above-described embodiments. A development process may be subsequently performed on the substrate arrangement. These process may be performed in the manufacture of semiconductors by a lithographic apparatus.

Embodiments include devices manufactured according to the method of embodiments.

Embodiments are set out in the following numbered clauses:
1. A lithographic apparatus comprising:
   an EUV source that comprises a laser; and
   a control system;
   wherein:
      the control system is configured to obtain timing data of intended exposure processes; and
      the control system is configured to determine, in dependence on at least the timing data, control data for changing the instantaneous output power of the laser such that, during the intended exposure processes, an average output power of the laser is substantially maintained at a constant level, or
      changes at, or slower than, a pre-determined rate.
2. The apparatus according to clause 1, wherein the control system is further configured to control the operation of the laser in dependence on the control data.
3. The apparatus according to clause 1 or 2, wherein the control system is configured to turn the laser on and off at times that are dependent on the control data.
4. The apparatus according to clause 3, wherein the control system is configured to set the output power of the laser in dependence on the control data.
5. The apparatus according to any preceding clause, wherein the control system is configured to obtain further data on one or more of the size and/or location of one or more fields on one or more substrates that will be exposed during the intended exposure processes, the intended dose that will be used in each intended exposure process, and throughput data of the lithographic apparatus; and
   the control system is configured to determine the control data in dependence on the obtained further data.
6. The apparatus according to any preceding clause, wherein the control system is configured to obtain operating data of exposure processes; and
   the control system is configured to determine, in dependence on at least the operating data, the control data of the laser.
7. The apparatus according to clause 6, wherein the operating data comprises data on actual output powers of the laser during exposure processes and the actual timings of performed exposure processes.
8. The apparatus according to any preceding clause, wherein the control data is configured to change the average output power of the laser at, or slower than, a pre-determined rate; and
   the predetermined rate is set such that appropriate performance of the EUV source is maintainable when the average output power of the laser changes.
9. The apparatus according to any preceding clause, wherein the average output power of the laser is a moving average of the instantaneous output power over a predetermined time period.
10. The apparatus according to any preceding clause, wherein the control system is configured to control the laser to:
   emit radiation with a first power when exposure processes are performed; and
   emit radiation with a second power between exposure processes;
   wherein the second power is less than the first power and greater than zero.
11. The apparatus according to any preceding clause, wherein the control system comprises a first control system and a second control system;
   the first control system is configured to generate the control data and to provide the control data to the second control system; and
   the second control system is configured to control the laser in dependence on the control data.
12. A method of controlling the operation of a laser of an EUV source in a lithographic apparatus, the method comprising:
   obtaining timing data of intended exposure processes; and
   determining, in dependence on at least the timing data, control data for changing the instantaneous output power of the laser such that an average output power of the laser is substantially maintained at a constant level, or changes at, or slower than, a pre-determined rate, during the intended exposure processes.
13. The method according to clause 12, further comprising controlling the operation of the laser in dependence on the control data.
14. The method according to clause 12 or 13, wherein the method comprises turning the laser on and off at times that are dependent on the control data.
15. The method according to clause 14, further comprising setting the power of the laser in dependence on the control data.
16. The method according to any of clauses 12 to 15, further comprising:
   obtaining further data on one or more of the size and/or location of one or more fields on one or more substrates that will be exposed during the intended exposure processes, the intended dose that will be used in each exposure process, and throughput data of the lithographic apparatus; and
   determining the control data in dependence on the obtained further data.
17. The method according to any of clauses 12 to 16, further comprising:
   obtaining operating data of exposure processes; and
   determining, in dependence on at least the operating data, the control data of the laser.
18. The method according to clause 17, wherein the operating data comprises data on actual output powers of the laser during exposure processes and the actual timings of performed exposure processes.
19. The method according to any of clauses 12 to 18, wherein the control data is configured to change the average output power of the laser at, or slower than, a pre-determined rate; and
   the predetermined rate is set such that appropriate performance of the EUV source is maintainable when the average output power of the laser changes.
20. The method according to any of clauses 12 to 19, wherein the average output power of the laser is a moving average of the instantaneous output power over a predetermined time period.
21. The method according to any of clauses 12 to 20, further comprising:
   emitting radiation from the laser with a first power when exposure processes are performed; and
   emitting radiation from the laser with a second power between exposure processes;
   wherein the second power is less than the first power and greater than zero.
22. An EUV source of a lithographic apparatus according to any of clauses 1 to 11.
23. A control system of a lithographic apparatus according to any of clauses 1 to 11.

Although specific reference may be made in this text to the use of lithographic apparatus in the manufacture of ICs, it should be understood that the lithographic apparatus described herein may have other applications. Possible other applications include the manufacture of integrated optical systems, guidance and detection patterns for magnetic domain memories, flat-panel displays, liquid-crystal displays (LCDs), thin-film magnetic heads, etc.

While specific embodiments of the invention have been described above, it will be appreciated that the invention may be practiced otherwise than as described. The descriptions above are intended to be illustrative, not limiting. Thus it will be apparent to one skilled in the art that modifications may be made to the invention as described without departing from the scope of the claims set out below.

## Claims

1. A lithographic apparatus comprising:
an EUV source that comprises a laser; and
a control system;
wherein:
the control system is configured to obtain timing data of intended exposure processes; and
the control system is configured to determine, in dependence on at least the timing data, control data for changing the instantaneous output power of the laser such that, during the intended exposure processes, an average output power of the laser is substantially maintained at a constant level, or changes at, or slower than, a pre-determined rate.

2. The apparatus according to claim 1, wherein the control system is further configured to control the operation of the laser in dependence on the control data.

3. The apparatus according to claim 1 or 2, wherein the control system is configured to turn the laser on and off at times that are dependent on the control data.

4. The apparatus according to claim 3, wherein the control system is configured to set the output power of the laser in dependence on the control data.

5. The apparatus according to any preceding claim, wherein the control system is configured to obtain further data on one or more of the size and/or location of one or more fields on one or more substrates that will be exposed during the intended exposure processes, the intended dose that will be used in each intended exposure process, and throughput data of the lithographic apparatus; and
the control system is configured to determine the control data in dependence on the obtained further data.

6. The apparatus according to any preceding claim, wherein the control system is configured to obtain operating data of exposure processes; and
the control system is configured to determine, in dependence on at least the operating data, the control data of the laser.

7. The apparatus according to claim 6, wherein the operating data comprises data on actual output powers of the laser during exposure processes and the actual timings of performed exposure processes.

8. The apparatus according to any preceding claim, wherein the control data is configured to change the average output power of the laser at, or slower than, a pre-determined rate; and the predetermined rate is set such that appropriate performance of the EUV source is maintainable when the average output power of the laser changes.

9. The apparatus according to any preceding claim, wherein the average output power of the laser is a moving average of the instantaneous output power over a predetermined time period.

10. The apparatus according to any preceding claim, wherein the control system is configured to control the laser to:
emit radiation with a first power when exposure processes are performed; and
emit radiation with a second power between exposure processes;
wherein the second power is less than the first power and greater than zero.

11. The apparatus according to any preceding claim, wherein the control system comprises a first control system and a second control system;
the first control system is configured to generate the control data and to provide the control data to the second control system; and
the second control system is configured to control the laser in dependence on the control data.

12. A method of controlling the operation of a laser of an EUV source in a lithographic apparatus, the method comprising:
obtaining timing data of intended exposure processes; and
determining, in dependence on at least the timing data, control data for changing the instantaneous output power of the laser such that an average output power of the laser is substantially maintained at a constant level, or changes at, or slower than, a pre-determined rate, during the intended exposure processes.

13. The method according to claim 12, further comprising controlling the operation of the laser in dependence on the control data.

14. The method according to claim 12 or 13, wherein the method comprises turning the laser on and off at times that are dependent on the control data.

15. The method according to claim 14, further comprising setting the power of the laser in dependence on the control data.

16. The method according to any of claims 12 to 15, further comprising:
obtaining further data on one or more of the size and/or location of one or more fields on one or more substrates that will be exposed during the intended exposure processes, the intended dose that will be used in each exposure process, and throughput data of the lithographic apparatus; and
determining the control data in dependence on the obtained further data.

17. The method according to any of claims 12 to 16, further comprising:
obtaining operating data of exposure processes; and
determining, in dependence on at least the operating data, the control data of the laser.

18. The method according to claim 17, wherein the operating data comprises data on actual output powers of the laser during exposure processes and the actual timings of performed exposure processes.

19. The method according to any of claims 12 to 18, wherein the control data is configured to change the average output power of the laser at, or slower than, a pre-determined rate; and the predetermined rate is set such that appropriate performance of the EUV source is maintainable when the average output power of the laser changes.

20. The method according to any of claims 12 to 19, wherein the average output power of the laser is a moving average of the instantaneous output power over a predetermined time period.

21. The method according to any of claims 12 to 20, further comprising:
emitting radiation from the laser with a first power when exposure processes are performed; and
emitting radiation from the laser with a second power between exposure processes;
wherein the second power is less than the first power and greater than zero.

22. An EUV source of a lithographic apparatus according to any of claims 1 to 11.

23. A control system of a lithographic apparatus according to any of claims 1 to 11.
